(19) **Europäisches Patentamt European Patent Office Office européen des brevets**

(11) **EP 1 174 927 B1**

(12) **FASCICULE DE BREVET EUROPEEN**

(45) Date de publication et mention
de la délivrance du brevet:
**21.11.2007 Bulletin 2007/47**

(51) Int Cl.:
***H01L 27/146*** *(2006.01)*

(21) Numéro de dépôt: **01401849.3**

(22) Date de dépôt: **10.07.2001**

(54) **Dispositif d'auto-compensation pour un système d'imagerie avec une architecture soustractive**

Selbstkompensierende Vorrichtung für ein Bilderzeugungssystem mit einer Substraktionsarchitektur

Auto-compensation device for an imaging system with a substraction architecture

(84) Etats contractants désignés:
**DE GB**

(30) Priorité: **11.07.2000 FR 0009052**

(43) Date de publication de la demande:
**23.01.2002 Bulletin 2002/04**

(73) Titulaire: **Thales**
**75008 Paris (FR)**

(72) Inventeurs:
• **Costard, Eric,**
**Thales Intellectual Property**
**94117 Arcueil Cedex (FR)**
• **Bois, Philippe,**
**Thales Intellectual Property**
**94117 Arcueil Cedex (FR)**
• **Audier, Marcel Francis,**
**Thales Intellectual Prop.**
**94117 Arcueil Cedex (FR)**

(56) Documents cités:
**EP-A- 0 664 554          EP-A- 0 849 798**

• **PATENT ABSTRACTS OF JAPAN vol. 2000, no. 07, 29 septembre 2000 (2000-09-29) & JP 2000 111397 A (NEC CORP), 18 avril 2000 (2000-04-18)**

**Description**

L'invention concerne un dispositif d'auto-compensation pour détecteurs soustractifs.

Le but de l'invention est l'amélioration des systèmes d'imagerie thermique utilisant une architecture soustractive pour éliminer la composante continue du courant intégré. Le principe d'un détecteur soustractif est décrit dans le brevet français n° 2 756 666 et est rappelé en figures 1a et 1b.

Comme cela est représenté de façon simplifiée sur la figure 1a, un détecteur selon le brevet français n° 2 756 666 comporte empilées sur un substrat :

- une couche de contact C2
- une couche active photoconductrice D2
- une couche de contact commune Cc
- une couche active photoconductrice D1
- et une couche de contact C1

Les couches actives photoconductrices D1, D2 peuvent être des couches en semiconducteur photoconducteur tel que du silicium. Elles peuvent être également réalisées sous forme d'empilement de couches constituant des détecteurs à puits quantiques. Les deux couches actives D1, D2 sont photoconductrices à une même gamme de longueurs d'onde λ. L'une des couches actives est conçue pour être très absorbante à la gamme de longueurs d'onde λ tandis que l'autre couche est prévue pour être très peu ou quasiment pas absorbante. Cela peut être prévu par des épaisseurs différentes des couches actives, ou par dopage plus important des couches de puits quantiques de la couche active plus absorbante. Les couches de contact C1, C2, Cc peuvent ne pas recouvrir toute la surface des couches photoconductrices.

Le détecteur étant éclairé par le rayonnement à détecter comme cela est représenté en figure 1a, la couche active D2 reçoit en premier le rayonnement RZ.

Dans le cas où la couche D1 est plus absorbante que la couche D2, on prévoit de préférence, associé à la face de la couche D1 qui porte la couche de contact C1, un réseau de diffraction. Ce réseau reçoit la lumière qui n'a pas été absorbée lors de la première traversée de la couche D1 et la diffracte vers la couche D1. La lumière diffractée sera absorbée ou quasi absorbée par la couche D1.

Les couches de contacts C1 et C2 permettent l'application de potentiels de commande. La couche de contact Cc est commune aux deux éléments détecteurs comprenant les couches actives photoconductrices.

Elle est mise à un potentiel de référence et permet la détection des photocourants générés par les détecteurs D1, D2.

Le substrat est transparent à la gamme de longueurs d'onde à mesurer. Le détecteur reçoit donc le rayonnement RZ à travers le substrat.

Lorsqu'un rayonnement RZ est reçu par le détecteur, pour détecter la longueur d'onde λ (ou gamme de longueurs d'ondes) on applique :

- un potentiel V1 à la couche de contact C1
- un potentiel V2 à la couche de contact C2
- un potentiel Vc flottant (ou masse) compris entre V1 et V2 à la couche de contact commune Cc.

Dans la structure D1 circule un courant

$$I1 = I1d + I1opt$$

et dans la structure D2 circule un courant

$$I2 = I2d + I2opt$$

Les courants I1d et I2d sont les courants d'obscurité dans D1 et D2. Les courants I1d et I2d peuvent également représenter la somme d'un courant d'obscurité et d'un courant de scène. Les courants I1opt et I2opt sont les courants dus à la longueur d'onde λ à détecter dans D1 et D2.

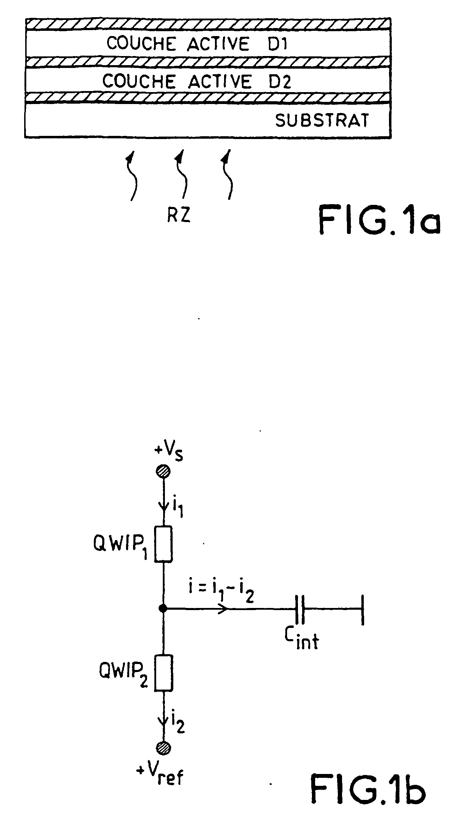

Selon la figure 1b, le courant i collecté par le circuit de lecture a pour valeur :

$$I = I1 - I2$$

En ajustant la tension V1 ou V2, il est possible d'ajuster I1d = I2d. La valeur du courant détecté est donc :

$$I = I1opt - I2opt$$

En prévoyant que l'une des deux couches actives n'absorbe que très peu d'énergie de l'onde λ, le courant I est donc celui généré par la couche active qui a la réponse la plus forte.

Le courant total d'un imageur thermique est la somme d'un courant d'offset, constitué du courant d'obscurité activé thermiquement selon une loi de type Arrhénius $I = I_0 \exp(-hc/\lambda)kT)$ et du courant de signal optique généré par les variations d'émissivité et de température de la scène. L'architecture d'un plan focal soustractif permet de soustraire la composante continue avant intégration, et donc d'utiliser complètement le temps trame disponible pour intégrer le signal sans saturer la capacité de stockage individuelle de chaque pixel, ce qui améliore le rapport signal/bruit des détecteurs. Les deux étages QWIP1 et QWIP2 sont de structures identiques, l'étage QWIP1, polarisé à $-V_s$ est l'étage de détection et l'étage QWIP2, contre-polarisé à $+V_{ref}$ est l'étage miroir de référence, permettant de soustraire totalement ou partiellement le courant. Le contact intermédiaire est relié à la capacité de stockage correspondante du multiplexeur et permet ainsi de recueillir le courant résultant, soit la différence des courants traversant les deux étages.

Un équipement d'imagerie thermique comporte un organe de refroidissement (machine Stirling, détendeur Joule-Thomson, bain d'azote liquide, ...) et un système de régulation capable de stabiliser la température du plan focal $T_0$ à $\pm \Delta T$ près. La fluctuation lente de température d'amplitude de variation $2\Delta T$ va engendrer une variation du courant thermique de chacun des étages.

L'invention permet de résoudre ce problème.

L'invention concerne donc un dispositif de détection d'onde électromagnétique comprenant au moins deux détecteurs d'onde électromagnétique à photoconducteur comportant chacun :

- au moins deux éléments détecteurs actifs à photoconducteurs empilés de forme plane, séparés par une couche de contact commune de lecture, l'ensemble étant enserré entre deux couches de contact de commande ;
- des moyens pour appliquer des tensions de commande à chaque couche de contact de commande, une tension appliquée à la couche de contact commune de lecture ayant une valeur comprise entre les tensions appliquées aux couches de contact de commande ;

des moyens connectés au contact commun permettant de détecter la différence des courants de photoconduction des deux éléments détecteurs, caractérisé en ce que les détecteurs sont munis, sur l'une de leurs faces planes, d'un réseau de diffraction, à l'excepté d'au moins un détecteur (DET') sans réseau de diffraction, et en ce qu'il comprend un circuit de soustraction pour soustraire le signal de lecture d'un détecteur sans réseau de diffraction, du signal de lecture d'un détecteur muni d'un réseau de diffraction.

Les différents objets et caractéristiques de l'invention apparaîtront plus clairement dans la description qui va suivre et dans les figures annexées qui représentent :

- les figures 1a et 1b, un détecteur soustractif selon l'art connu ;
- la figure 2, un exemple simplifié d'un dispositif de détection selon l'invention ;
- les figures 3a et 3b, une matrice de détection selon l'invention ;
- la figure 4, une organisation d'une matrice selon l'invention ;
- la figure 5, la répartition des différentes contributions au courant total ;
- la figure 6, un circuit électronique permettant de soustraire à la lecture d'un détecteur d'une matrice, la lecture d'un détecteur servant à mesurer le courant thermique.

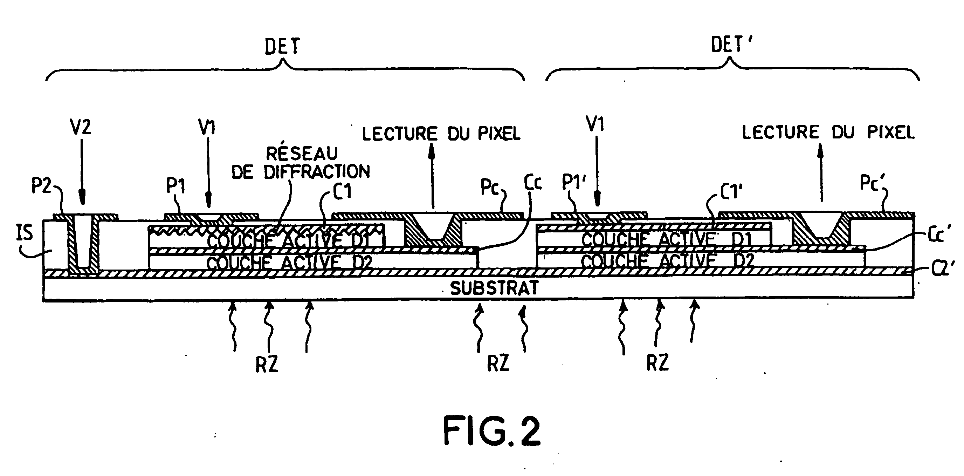

La figure 2 représente un dispositif de détection selon l'invention. Il comporte essentiellement et au minimum deux détecteurs DET et DET'.

Le détecteur DET est réalisé de manière similaire au détecteur de la figure 1a. Il comporte les couches photo-toconductrices actives D1, D2 et les couches de contact C1, C2, Cc.

Préférentiellement, le détecteur est encapsulé dans un matériau isolant IS. Des plots de contacts P1, P2, PC permettent de se connecter aux couches de contact et traversent le matériau IS lorsque celui-ci a été prévu.

Un réseau de diffraction est prévu à la surface de la couche D1.

Le détecteur DET' est similaire au détecteur DET. Il peut être même réalisé dans des couches quasiment identiques à celles du détecteur DET. Il comporte donc les couches photoconductrices D1', D2' et les couches de contact C1', C2' et Cc'. Par contre, le détecteur DET' ne comporte pas de réseau de diffraction. Dans ces conditions, la soustraction de la mesure de courant du détecteur DET' à la mesure de courant du

Un exemple de circuit permettant de réaliser cette soustraction sera décrit ultérieurement en application à une matrice de détecteurs.

On va tout d'abord décrire une matrice de détecteurs selon l'invention.

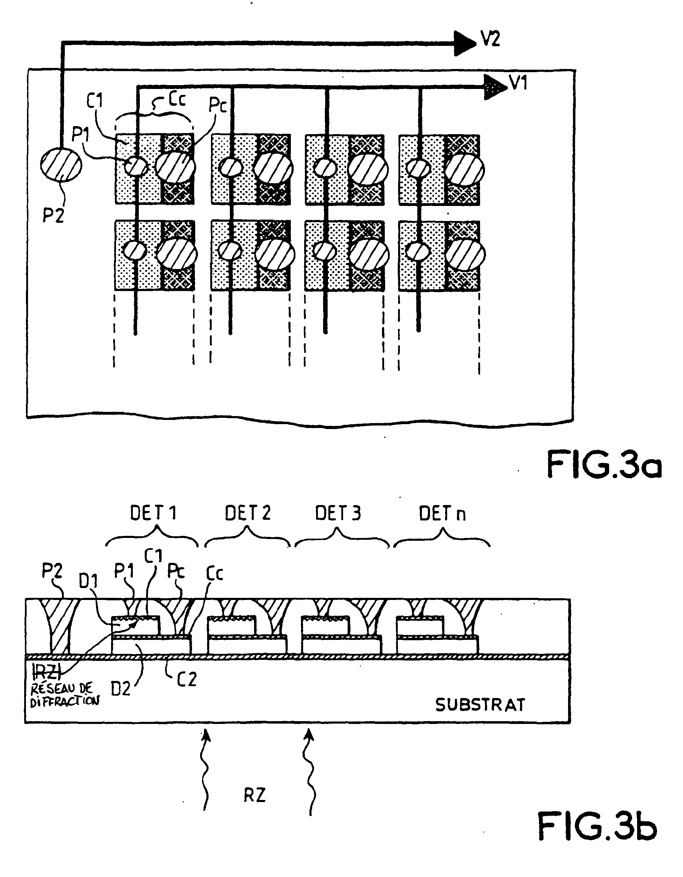

Les figures 3a et 3b représentent en vue de dessus et en coupe une forme de réalisation matricielle d'un détecteur bispectral selon l'invention.

Les différents détecteurs sont réalisés sur une couche de contact de commande C2 commune à tous les détecteurs. Le plot de connexion P2 est donc commun à toute la matrice. Chaque détecteur de la matrice comporte un élément détecteur D1 et un élément détecteur D2 ainsi que les couches de contacts C1 et Cc et les plots de connexion P1 et Pc. Les plots de connexion P1 sont tous connectés entre eux pour appliquer un potentiel V1 (voir précédemment) à tous les éléments détecteurs D1 de la matrice. La couche de contact C2 et le plot de connexion P2 étant communs à toute la matrice, le potentiel V2 appliqué au plot P2 est appliqué à tous les éléments détecteurs D2 de la matrice.

Pour la lecture des détecteurs de la matrice, chaque détecteur est situé au point de croisement d'un réseau de conducteurs de lignes et de colonnes. A chaque point de croisement est prévu par exemple un transistor Tr dont la base est connectée au fil de ligne. L'émetteur et le collecteur sont connectés respectivement à un plot Pc et à un fil de colonne. L'application d'un potentiel approprié sur un fil de ligne permet de commander tous les transistors de la ligne et de connecter tous les plots Pc d'une ligne à des fils de colonne. Il est ainsi possible de lire, sur chaque fil de colonne, le photocourant généré par le détecteur connecté à ce fil de colonne.

Dans cet exemple de réalisation, toutes les couches C1 sont interconnectées entre elles et commandées par un même potentiel. Il en est de même pour les couches de contacts C2 qui sont connectées au plot P2.

Cependant, selon une variante de réalisation, on prévoit que la couche de contact de commande C2 est découpée en bandes de façon que chaque bande soit commune à une ligne de détecteurs. On aura alors un plot P2 par bande de contact C2, c'est-à-dire par ligne de détecteurs.

De façon similaire, au lieu d'interconnecter tous les plots P1, on les interconnecte par lignes de détecteurs. On a un plot P1 par ligne de détecteurs.

Les plots Pc des détecteurs sont interconnectés par des fils de colonnes de la matrice.

Le fonctionnement de la matrice de détecteurs se fait alors séquentiellement par ligne.

Comme on peut le voir sur la figure 3b, les détecteurs DET1 à DET3 comportent à la surface de leur couche photoconductrice D1, un réseau de diffraction Par contre, le détecteur DETn ne comporte pas un tel réseau de diffraction.

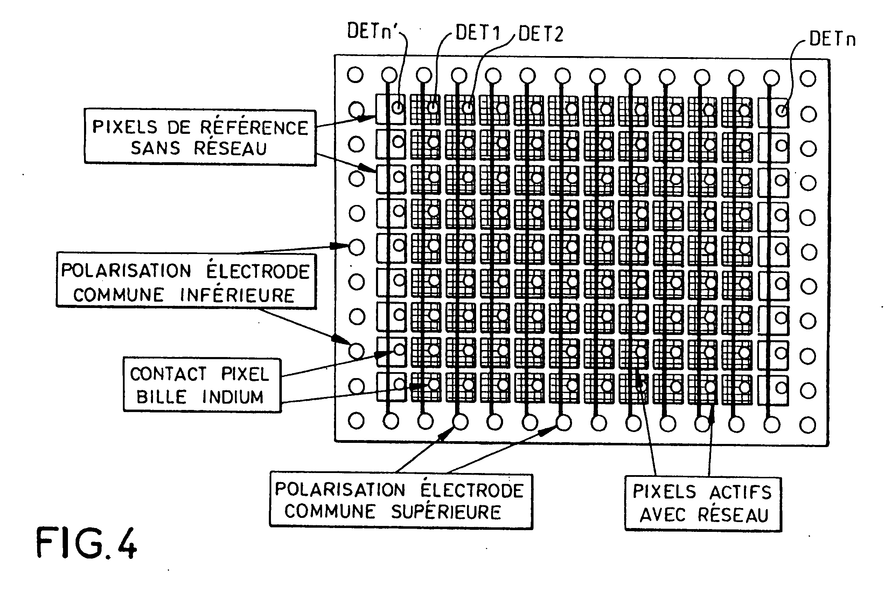

La figure 4 représente une autre vue de dessus d'une matrice de détecteurs ainsi conçue. La première ligne de la matrice comporte les détecteurs DET1, DET2, ... DETn. On a prévu également à gauche, un détecteur DETn' similaire au détecteur DETn (donc sans réseau de diffraction). Les détecteurs DETn, DETn' serviront à fournir le signal de compensation en température pour les détecteurs de la ligne.

Les autres lignes de la matrice sont conçues de la même façon.

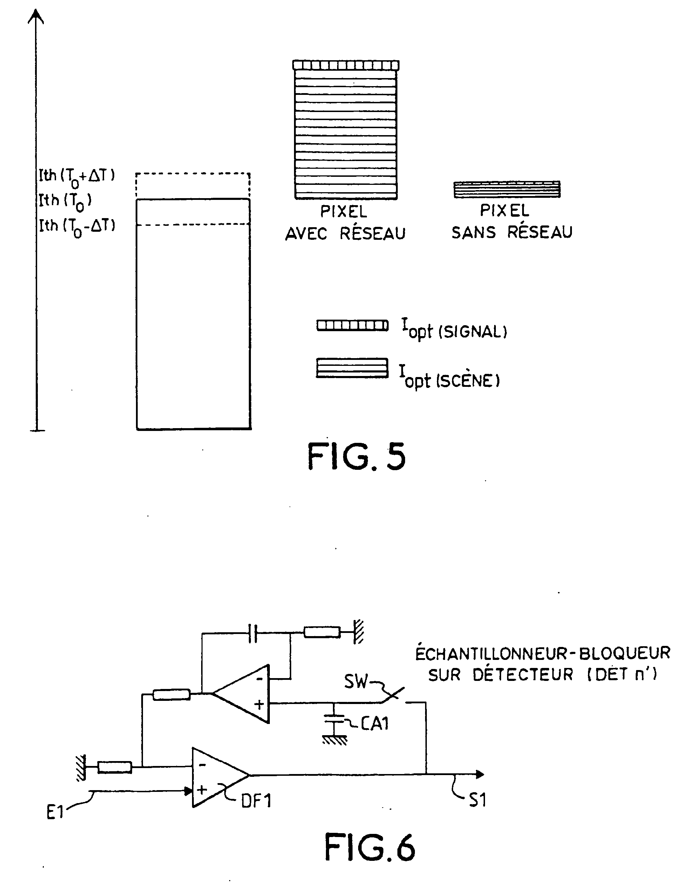

Dans un mode de fonctionnement nominal, le taux de soustraction devra être inférieur à 100 %, afin de préserver une réserve de dynamique au système (voir figure 5). Dans ces conditions, il subsistera donc dans le courant intégré une partie du courant d'origine thermique et le signal stocké dans la capacité d'intégration variera lentement selon les fluctuations de température. L'effet indésirable sera une dérive d'offset du signal de sortie du plan focal et donc une fluctuation lente du niveau de gris moyen de l'image.

Le principe de l'invention est de fournir, à l'électronique de traitement de la caméra, l'information concernant le niveau résiduel du courant d'origine thermique dans les signaux intégrés, dans les conditions de taux de soustraction et de température de fonctionnement de chaque trame vidéo. La carte d'électronique de proximité de la caméra comprendra un circuit comparateur qui permettra d'ajuster le niveau d'offset (figure 6).

Le principe du détecteur soustractif repose sur le fait que le réseau de diffraction réalisé sur l'électrode supérieure du pixel assure d'une part l'amplification de la réponse et d'autre part la différenciation de réponse optique entre les deux étages ($R_1/R_2 = \beta$). Sans réseaux, les deux étages d'un pixel soustractif ont la même valeur faible de réponse optique $R_0/R_1\eta_{res}$. Ainsi pour un taux de soustraction $\gamma$, le signal intégré sur des pixels munis de réseau sera :

$$I_{res} = (1-\gamma)\,I_{th}(T) + R_1 P_{opt}\left(1-\frac{\gamma}{\beta}\right)$$

et vaudra pour des pixels sans réseaux :

$$I_{ss\,res} = (1-\gamma)I_{th}(T) + R_0P_{opt}(1-\gamma)$$

Dans le cas d'un fonctionnement à une température où le courant généré thermiquement est prépondérant (régime « haute température », pour lequel $R_1P_{opt} > I_{th}(T)$), le signal intégré sur des pixels sans réseau est approximativement réduit à la composante thermique du courant intégré, soit $(1-\gamma)I_{th}(T)$.

A titre d'exemple, une application numérique fournit les valeurs suivantes :

$$\gamma = 0.9,\ \beta = 5,\ \eta_{res} = 10 : I_{res}^{opt} = 0.82.\ R_1P_{opt}\ \text{peut être comparable à}\ (1\text{-}\gamma)\ I_{th}(T)$$

alors que

$$I_{ss\,res}^{opt} = 0.01.\ R_1\ P_{opt} << (1\text{-}\gamma)\ I_{th}(T)$$

Le circuit de la figure 6 permet d'effectuer la lecture d'un détecteur tel que DETn' et d'enregistrer la lecture dans le condensateur CA1. Pour cette lecture, l'entrée E1 est connectée au plot de lecture (Pc) de DETn'. Ensuite, l'entrée E1 est connectée, par des moyens non représentés, successivement aux plots de lecture Pc des différents détecteurs DET1, DET2, etc d'une ligne. A chaque lecture d'un détecteur, tel que DET1, un courant correspondant au courant de lecture du détecteur DETn', dont la lecture a été enregistrée dans le condensateur CA1, est soustrait du courant de lecture du détecteur DET1 lu et cela par le circuit différentiel DF1. La sortie S1 fournit ainsi sur sa sortie S1, le courant de lecture dont on a réduit le courant dû au bruit thermique. Les mesures se font ainsi de suite pour les différents détecteurs d'une ligne, puis pour les lignes de détecteurs suivantes.

Enfin, pour être complet, le système d'électronique de proximité pourra comparer le signal de référence thermique de la colonne 0 et n+1 de la trame i, à ceux de référence de la trame i-1, afin d'éliminer le risque d'une correction indue occasionnée par l'apparition d'un point chaud à la périphérie du champ de vision de l'imageur et détecté par le niveau résiduel très faible (mais non nul) de réponse optique sur ces pixels de référence.

**Revendications**

**1.** Dispositif de détection d'onde électromagnétique comprenant au moins deux détecteurs d'onde électromagnétique (DET, DET') à photoconducteur comportant chacun :

   - au moins deux éléments détecteurs actifs à photoconducteurs (D1, D2) empilés de forme plane, séparés par une couche de contact commune de lecture (Cc), l'ensemble étant enserré entre deux couches de contact de commande (C1, C2) ;
   - des moyens pour appliquer des tensions de commande (V1, V2) à chaque couche de contact de commande (C1, C2), une tension appliquée à la couche de contact commune de lecture ayant une valeur comprise entre les tensions (V1, V2) appliquées aux couches de contact de commande ;

   des moyens connectés au contact commun (Cc) permettant de détecter la différence des courants de photoconduction des deux éléments détecteurs, **caractérisé en ce que** les détecteurs sont munis, sur l'une de leurs faces planes, d'un réseau de diffraction, à l'excepté d'au moins un détecteur (DET') sans réseau de diffraction, et **en ce qu'**il comprend un circuit de soustraction pour soustraire le signal de lecture d'un détecteur sans réseau de diffraction, du signal de lecture d'un détecteur muni d'un réseau de diffraction.

**2.** Dispositif de détection selon la revendication 1, **caractérisé en ce qu'**il comporte une matrice de détecteurs arrangés en lignes et colonnes, chaque ligne comportant au moins un détecteur supplémentaire (DETn') sans réseau de diffraction.

**3.** Dispositif selon la revendication 2, **caractérisé en ce qu'**il comporte au moins un circuit de soustraction par ligne de détecteurs, ledit circuit enregistrant tout d'abord la lecture du détecteur supplémentaire (DETn') puis soustrayant à la lecture de chaque détecteur de cette ligne, la lecture de ce détecteur supplémentaire.

**4.** Dispositif selon la revendication 3, **caractérisé en ce qu'**il comporte un circuit mémoire, tel qu'un condensateur (C1), mémorisant la lecture du détecteur supplémentaire, ainsi qu'un différentiateur connectable successivement aux contacts communs des différents détecteurs de la ligne et effectuant à chaque connexion à un détecteur, la soustraction au courant lu par ce détecteur, d'un courant correspondant à la lecture mémorisée du détecteur supplémentaire.

**Claims**

**1.** Electromagnetic wave detection device comprising at least two photoconducting electromagnetic wave detectors (DET, DET'), each comprising:

- at least two stacked photoconducting active detector elements (D1, D2) of plane shape that are separated by a common read contact layer (Cc), the assembly being sandwiched between two control contact layers (C1, C2); and
- means for applying control voltages (V1, V2) to each control contact layer (C1, C2), a voltage applied to the common read contact layer having a value between the voltages (V1, V2) applied to the control contact layers,

means connected to the common contact (Cc) making it possible to detect the difference between the photoconduction currents of the two detector elements, **characterized in that** the detectors are provided, on one of their plane faces, with a diffraction grating, except for at least one detector (DET') with no diffraction grating, and **in that** it includes a subtraction circuit for subtracting the read signal of a detector without a diffraction grating from the read signal of a detector provided with a diffraction grating.

**2.** Detection device according to Claim 1, **characterized in that** it comprises a matrix of detectors arranged in rows and columns each row having at least one additional detector (DETn') without a diffraction grating.

**3.** Device according to Claim 2, **characterized in that** it comprises at least one subtraction circuit per row of detectors, said circuit firstly recording the reading of the additional detector (DETn') and then subtracting from the reading of each detector of this row the reading of this additional detector.

**4.** Device according to Claim 3, **characterized in that** it comprises a memory circuit, such as a capacitor (C1), storing the reading of the additional detector, and also a differentiator that can be connected in succession to the common contacts of the various detectors of the row and carries out, at each connection to a detector, the subtraction, from the current read by this detector, of the current corresponding to the stored reading of the additional detector.

**Patentansprüche**

**1.** Vorrichtung zum Erfassen von elektromagnetischen Wellen, die wenigstens zwei Photoleiter-Detektoren (DET, DET') für elektromagnetische Wellen enthält, wovon jeder enthält:

- wenigstens zwei aktive Photoleiter-Detektorelemente (D1, D2), die in ebener Form gestapelt und durch eine gemeinsame Lese-Kontaktschicht (Cc) getrennt sind, wobei die Gesamtheit zwischen zwei Steuer-Kontaktschichten (C1, C2) eingebettet ist;
- Mittel zum Anlegen von Steuerspannungen (V1, V2) an jede Steuer-Kontaktschicht (C1, C2), wobei eine an die gemeinsame Lese-Kontaktschicht angelegte Spannung einen Wert besitzt, der zwischen den an die Steuer-Kontaktschichten angelegten Spannungen (V1, V2) liegt;

wobei Mittel, die an den gemeinsamen Kontakt (Cc) angeschlossen sind, erlauben, die Differenz der Photoleitungsströme der zwei Detektorelemente zu erfassen, **dadurch gekennzeichnet, dass** die Detektoren mit Ausnahme wenigstens eines Detektors (DET'), der kein Beugungsgitter besitzt, auf einer ihrer ebenen Flächen mit einem Beugungsgitter versehen sind und dass sie eine Subtraktionsschaltung enthält, um das Lesesignal eines Detektors ohne Beugungsgitter von dem Lesesignal eines mit einem Beugungsgitter versehenen Detektors zu subtrahieren.

2. Erfassungsvorrichtung nach Anspruch 1, **dadurch gekennzeichnet, dass** sie eine Matrix aus Detektoren enthält, die in Zeilen und Spalten angeordnet sind, wobei jede Zeile wenigstens einen zusätzlichen Detektor (DETn') ohne Beugungsgitter enthält.

3. Vorrichtung nach Anspruch 2, **dadurch gekennzeichnet, dass** sie wenigstens eine Subtraktionsschaltung pro Detektorzeile enthält, wobei die Schaltung zunächst die Ablesung des zusätzlichen Detektors (DETn') aufzeichnet und dann von der Ablesung jedes Detektors dieser Zeile die Ablesung dieses zusätzlichen Detektors subtrahiert.

4. Vorrichtung nach Anspruch 3, **dadurch gekennzeichnet, dass** sie eine Speicherschaltung wie etwa einen Kondensator (C1), der die Ablesung des zusätzlichen Detektors speichert, und einen Differenzierer enthält, der nacheinander an die gemeinsamen Kontakte der verschiedenen Detektoren der Zeile angeschlossen werden kann und bei jedem Anschließen an einen Detektor die Subtraktion eines Stroms, der der gespeicherten Ablesung des zusätzlichen Detektors entspricht, von dem von jenem Detektor gelesenen Strom ausführt.

COUCHE ACTIVE D1

COUCHE ACTIVE D2

SUBSTRAT

RZ

# FIG.1a

$+V_S$

$i_1$

$QWIP_1$

$i = i_1 - i_2$

$C_{int}$

$QWIP_2$

$i_2$

$+V_{ref}$

# FIG.1b

FIG.2

FIG.3a

FIG.3b

FIG.4

Ith$(T_0+\Delta T)$
Ith$(T_0)$
Ith$(T_0-\Delta T)$

PIXEL
AVEC RÉSEAU

PIXEL
SANS RÉSEAU

$I_{opt}$ (SIGNAL)

$I_{opt}$ (SCÈNE)

FIG.5

ÉCHANTILLONNEUR-BLOQUEUR
SUR DÉTECTEUR (DET n')

SW

CA1

E1

DF1

S1

FIG.6

## EP 1 174 927 B1